# EUROPEAN PATENT SPECIFICATION

(11) **EP 0 771 611 B1**
(45) Date of publication and mention of the grant of the patent: **29.01.2003**
(21) Application number: 96117500.7
(22) Date of filing: 31.10.1996
(51) Int. Cl.: B24B 37/04, B24B 49/16

(54) **Method and apparatus for determining endpoint in polishing process**
Verfahren und Gerät zur Ermittlung des Endes eines Polierverfahrens
Méthode et appareil pour déterminer la fin d'un procédé de polissage

(30) Priority: 02.11.1995 JP 30998295
(43) Date of publication of application: 07.05.1997
(73) Proprietor: EBARA CORPORATION, Ohta-ku, Tokyo (JP); KABUSHIKI KAISHA TOSHIBA, Kawasaki-shi, Kanagawa-ken 210-8572 (JP)
(72) Inventor: Takahashi, Tamami, Yamato-shi, Kanagawa-ken (JP); Sakata, Fumihiko, Yokohama-shi, Kanagawa-ken (JP); Kimura, Norio, Fujisawa-shi, Kanagawa-ken (JP); Kodera, Masako, Yokohama-shi, Kanagawa-ken (JP); Shigeta, Atsushi, Fujisawa-shi, Kanagawa-ken (JP)
(74) Representative: Wagner, Karl H., Dipl.-Ing.

(56) References cited:
- EP-A- 0 616 362
- GB-A- 2 275 130
- US-A- 5 036 015
- US-A- 5 069 002
- US-A- 5 308 438

## Description

### BACKGROUND OF THE INVENTION

### Field of the Invention:

The present invention relates to a method for determining an endpoint in a polishing process, and more particularly to a method for determining a planar endpoint on a workpiece such as a semiconductor wafer in a polishing process for polishing the workpiece to a flat mirror finish.

### Description of the Related Art:

Recent rapid progress in semiconductor device integration demands smaller and smaller wiring patterns or interconnections and also narrower spaces between interconnections which connect active areas. One of the processes available for forming such interconnections is photolithography. Though the photolithographic process can form interconnections that are at most 0.5 µm wide, it requires that surfaces on which pattern images are to be focused by a stepper be as flat as possible because the depth of focus of the optical system is relatively small.

It is therefore necessary to make the surfaces of semiconductor wafers flat for photolithography. One customary way of flattening the surfaces of semiconductor wafers is to polish them with a polishing apparatus.

Conventionally, a polishing apparatus has a turntable and a top ring which rotate at respective individual speeds. A polishing cloth is attached to the upper surface of the turntable. A semiconductor wafer to be polished is placed on the polishing cloth and clamped between the top ring and the turntable. An abrasive liquid containing abrasive grains is supplied onto the polishing cloth and retained on the polishing cloth. During a polishing process, the top ring exerts a certain pressure on the turntable, and the surface of the semiconductor wafer held against the polishing cloth is therefore polished to a flat mirror finish while the top ring and the turntable are rotating.

After the semiconductor wafer having an uneven or irregular surface is polished to a flat surface, the polishing process should be stopped at a desired timing, i.e. a desired surface height of the semiconductor wafer. However, the timing when the polishing process is terminated cannot be easily determined for the following reasons:
(1) In the polishing apparatus described above, since the entire surface to be polished of the semiconductor wafer is in sliding contact with the polishing cloth, the surface which is being polished is not exposed outwardly.
(2) The semiconductor wafer is wet with the abrasive liquid supplied thereto during the polishing process.
(3) Recent polishing technique requires a surface finishing on the order of angstroms (Å), but there are extremely limited techniques available for accurately measuring this high level of surface finishing.
(4) An endpoint, which is required, on the semiconductor wafer depends on the type of the semiconductor wafer.

Therefore, there has been a demand for techniques which can accurately determine an endpoint on a semiconductor wafer in the polishing process.

Attention is drawn to GB-A-2,275,130 which discloses an apparatus and a method for planarizing an insulating film formed on a semiconductor substrate, drive shafts of the polishing apparatus are fitted with sensors to measure the distortion of the shafts. This distortion is taken as a measure of friction between a wafer and a polishing plane. A ratio of frictional forces at different times is used to determine when polishing should be terminated. This ratio is calculated in an arithmetic unit and it may also be used to indicate when a new polishing plane is needed.

US-A-5,069,002 relates to an apparatus for detecting a planar endpoint on a semiconductor wafer during mechanical planarization of the wafer. The planar endpoint is detected by sensing a change in friction between the wafer and a polishing surface. This change of friction may be produced when, for instance, an oxide coating of the wafer is removed and a harder material is contacted by the polishing surface. In a preferred form, the change of friction is detected by rotating the wafer and polishing surface with electric motors and measuring current changes on one or both of the motors. This current change can then be used to produce a signal to operate control means for adjusting or stopping the process.

US-A-5,036,015 discloses a similar method and apparatus.

US-A-5,308,438 also relates to an endpoint detecting apparatus and method for chemical/mechanical polishing.

### SUMMARY OF THE INVENTION

It is therefore an object of the present invention to provide a method for determining an endpoint in a polishing process, for polishing a workpiece such as a semiconductor wafer having an uneven surface to a flat mirror finish, which can determine an endpoint on the workpiece at a desired timing or point.

The invention is defined in claim 1. Dependent claim 2 to 6 relate to preferred embodiments of the invention.

According to the present invention, inasmuch as the time when the workpiece having an uneven or irregular surface is polished to a flat surface can be detected on the basis of a change in a frictional force between the workpiece and the polishing platen, an endpoint on the workpiece can be determined on a real-time basis during polishing. Since a certain period of polishing time is set from a reference time when the workpiece having an uneven surface is polished to a flat surface, the endpoint on the workpiece can be determined at a desired point, and thus this method can meet a demand for determining various endpoints.

Since a change in a frictional force can be detected by a change in current of a driving motor for a polishing platen or a holding member such as a top ring, a small change in the frictional force can be detected. Further, since the polishing time from the time when an uneven surface of the workpiece is changed into a flat surface can be corrected in succession on the basis of data obtained from the previous polishing operations, it is possible to comply with a change in a polishing rate with time.

The above and other objects, features, and advantages of the present invention will become apparent from the following description when taken in conjunction with the accompanying drawings which illustrate preferred embodiments of the present invention by way of example.

### BRIEF DESCRIPTION OF THE DRAWINGS

FIG. 1 is a schematic front view showing a polishing apparatus having an endpoint detection device;
FIG. 2A is an enlarged cross-sectional view showing one example of a semiconductor wafer before and after a polishing process;
FIG. 2B is an enlarged cross-sectional view showing another example of a semiconductor wafer before and after a polishing process; and
FIG. 3 is a graph showing a change in a frictional force between a semiconductor wafer and a polishing cloth during the polishing process.

### DESCRIPTION OF THE PREFERRED EMBODIMENTS

A method for determining an endpoint in a polishing process according to an embodiment of the present invention will be described below with reference to drawings.

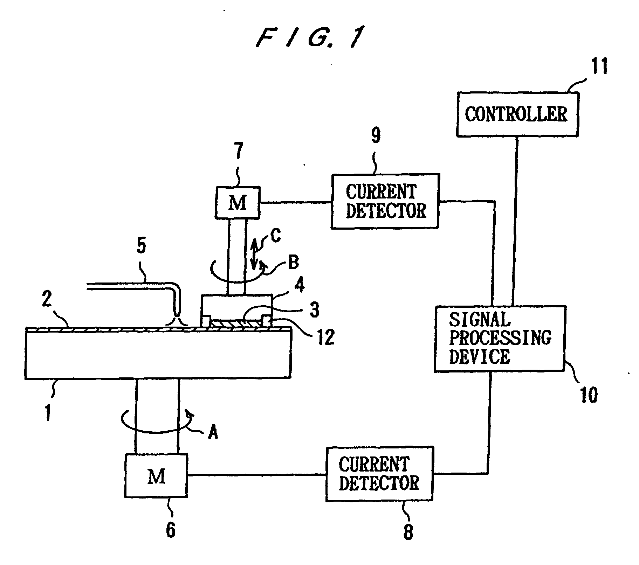

FIG. 1 is a schematic front view showing a polishing apparatus having an endpoint detection device. The polishing apparatus comprises a turntable 1, a polishing cloth 2 attached to an upper surface of the turntable 1, and a top ring 4 for holding a semiconductor wafer 3 and pressing the semiconductor wafer 3 against the polishing cloth 2. The polishing cloth 2 constitutes a polishing platen which contacts the semiconductor wafer 3. The turntable 1 is rotatable about its own axis as indicated by the arrow A by a first motor 6 which is coupled to the turntable 1. The top ring 4 is coupled to a second motor 7 and also to a lifting/lowering cylinder (not shown). The top ring 4 is vertically movable and rotatable about its own axis as indicated by the arrows B, C by the second motor 7 and the lifting/lowering cylinder.

The polishing apparatus further includes a first motor current detector 8 connected to the first motor 6 which rotates the turntable 1, a second motor current detector 9 connected to the second motor 7 which rotates the top ring 4, and a signal processing device 10 connected to the first and second current detectors 8 and 9 for determining an endpoint in a polishing process. The signal processing device 10 is connected to a controller 11 which controls the overall operation of the polishing apparatus.

The top ring 4 which holds a semiconductor wafer 3, with a surface to be polished facing downward, presses the semiconductor wafer 3 against the polishing cloth 2 under a desired pressure. The semiconductor wafer 3 is attached to a lower surface of the top ring 4 under a vacuum or the like. A guide ring 12 is mounted on the outer circumferential edge of the lower surface of the top ring 4 for preventing the semiconductor wafer 3 from being disengaged from the top ring 4. An abrasive liquid supply nozzle 5 is disposed above the turntable 1 for supplying an abrasive liquid onto the polishing cloth 2 attached to the turntable 1.

The polishing apparatus operates as follows: The semiconductor wafer 3 is held on the lower surface of the top ring 4, and pressed against the polishing cloth 2 on the upper surface of the turntable 1. The turntable 1 and the top ring 4 are rotated relatively to each other for thereby bringing the lower surface of the semiconductor wafer 3 in sliding contact with the polishing cloth 2. At this time, the abrasive liquid nozzle 5 supplies the abrasive liquid to the polishing cloth 2. The lower surface of the semiconductor wafer 3 is now polished by a combination of a mechanical polishing action of abrasive grains in the abrasive liquid and a chemical polishing action of a chemical solution such as an alkaline solution in the abrasive liquid.

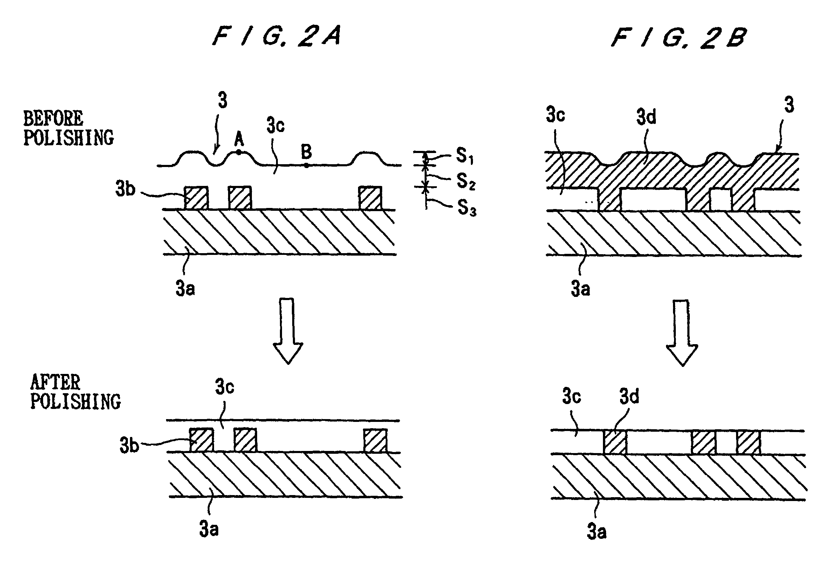

FIG. 2A is a cross-sectional view showing one example of a semiconductor wafer before and after a polishing process. As shown in FIG. 2A, the semiconductor wafer 3 comprises a silicon substrate (Si) 3a, metal wiring patterns 3b formed on the silicon substrate 3a, and an insulating layer 3c made of silicon dioxide (SiO₂) which covers the metal wiring patterns 3b and the silicon substrate 3a. The silicon substrate 3a has a flat surface, but formation of the metal wiring patterns 3b make the surface of the silicon substrate 3a uneven. Thus, the insulating layer 3c formed on the metal wiring patterns 3b and the silicon substrate 3a has an uneven upper surface.

Recent higher integration in semiconductor devices demands smaller wiring patterns and more multilayer, and hence more and more planarized finish of the semiconductor wafer. In order to meet the higher integration, an ultraviolet ray having a shorter wavelength, such as a g-beam or an i-beam, is used in photolithography. When the light having a shorter wavelength is used in photolithography, an allowable difference of elevation on the surface of the semiconductor wafer is small because the depth of focus of the optical system is relatively small. Thus, a high degree of flatness of the semiconductor wafer is required at a focal point of the ultraviolet ray.

As described above, one customary way of flattening an uneven surface of the semiconductor wafer is to polish it with the polishing apparatus. In a polishing process, after a certain period of polishing time, the polishing process is required to be stopped at a desired timing. In other words, it is desirable that the polishing process is terminated at a desired surface height of the semiconductor wafer after a certain period of polishing time. In some cases, the insulating layer 3c having a certain thickness must be left on the metal wiring patterns 3b as shown in FIG. 2A. In the upper part of FIG. 2A, the semiconductor wafer 3 before the polishing process is illustrated, and in the lower part of FIG. 2A, the semiconductor wafer 3 after the polishing process is illustrated. In the case where after the polishing process, another layer such as a metallic layer is formed on the insulating layer 3c, the insulating layer 3c is called an interlayer insulator. In this case, when the insulating layer 3c is excessively polished, the metal wiring patterns 3b will be exposed. Therefore, the polishing process must be terminated so as to leave the insulating layer 3c having a certain thickness, on the metal wiring patterns 3b, which is to be an interlayer insulator.

Next, a method which fulfills the foregoing demand will be described.

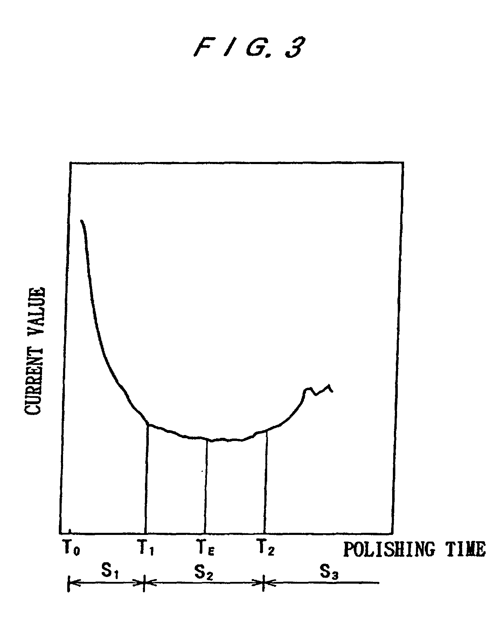

FIG. 3 is a graph showing the relationship between current value of the first motor 6 and the polishing time during a polishing process. The first motor 6 rotates the turntable 1. The current value of the first motor 6 is detected and processed in accordance with a predetermined signal processing by the first motor current detector 8 to thus obtain current value shown in FIG. 3. In FIG. 3, the horizontal axis represents the polishing time, and the vertical axis represents the current value of the first motor 6.

At a time T0, a polishing process of the semiconductor wafer 3 is started. A frictional force between the semiconductor wafer 3 and the polishing cloth 2 decreases as the polishing process progresses. At a time T1, the frictional force becomes relatively stable. This is because the semiconductor wafer 3 having an uneven surface is polished to a flat surface. Based on a change in the frictional force, the time T1 is regarded as a reference time when the uneven surface is polished to a flat surface. At this time, the difference of elevation on the surface of the semiconductor wafer 3 disappears, and the surface of the semiconductor wafer 3 which is being polished is shifted from the highest point A to the lowermost point B in FIG. 2A. The interlayer insulator 3c can be left by continuing polishing of the semiconductor wafer 3 for a certain period of time from the time T1 until the layer underneath the lowermost point B is exposed outwardly. The polishing time from the time T1 is obtained by dividing a desired amount of material removed from the semiconductor wafer after the flat surface is obtained, by an estimated polishing rate. In this case, the estimated polishing rate has been obtained from the polishing amount, i.e. the amount of material removed from the semiconductor wafer and the polishing time of the semiconductor wafer beforehand. To be more specific, the estimated polishing rate is determined based on a polishing amount and a polishing time of at least one semiconductor wafer which has been polished immediately before polishing the semiconductor wafer which is an object for determining an endpoint. The endpoint in the polishing process is determined so as to allow the interlayer to be left by setting the polishing time in the above manner. In one example of FIG. 3, the time TE within the time S2 between the time T1 and the time T2 is determined as an endpoint in the polishing process.

The electric current of the first motor 6 is detected by the first motor current detector 8, and the detected electric current signal is sent to the signal processing device 10. In the signal processing device 10, the electric current signal is processed to eliminate noise and further to determine the reference time when the uneven surface is polished to a flat surface, and the polishing time from the reference time is calculated on the basis of the polishing rate which has been inputted to the signal processing device 10. The signal processing device 10 sends an endpoint signal to the controller 11 when the calculated polishing time has elapsed, and the controller 11 stops the polishing process of the polishing apparatus.

The frictional force between the semiconductor wafer 3 and the polishing cloth 2 attached to the turntable 1 acts as a friction torque against the turntable 1. This means that a change in a frictional force can be measured as a change in a torque applied to the turntable 1. When the turntable is rotated by an electrical motor, a change in a torque is indirectly measured as a change in electric current of the electric motor.

In the above description, although the electric current of the first motor 6 which rotates the turntable 1 is used for determining an endpoint in the polishing process, the electric current of the second motor 7 which rotates the top ring 4 may be also used for determining an endpoint in the polishing process. In this case, the electric current of the second motor 7 is detected by the second motor current detector 9, and is processed by the signal processing device 10.

Referring again to FIG. 3, after the time T2, the metal wiring patterns 3b (see FIG. 2A) is exposed outwardly, and a change in a frictional force increases during the polishing operation, as shown in FIG. 3. In FIG. 3, the time S1 corresponds to the time during which the uneven surface is polished, the time S2 corresponds to the time during which the flat surface is polished, and the time S3 corresponds to the time during which the layer including a different material is polished, each of which corresponds to the thicknesses S1, S2, S3 of the semiconductor wafer, respectively, in FIG. 2A.

It is known that the polishing rate generally changes with deterioration with age in the polishing cloth, and other unknown factors. If the polishing rate is set to be constant in determining the polishing time from the reference time when an uneven surface is polished to a flat surface, since a change in the polishing rate is not taken into consideration, the polishing amount will be insufficient or excessive. In order to avoid such an insufficient or excessive polishing, the polishing amount of the semiconductor wafer may be measured to correct the polishing rate, as required. The polishing amount is obtained as the difference between the thicknesses of the layer before and after polishing. Since the polishing rate of each semiconductor wafer usually varies, an average polishing rate of a plurality of semiconductor wafers which have been polished immediately before polishing the semiconductor wafer which is an object for determining an endpoint may be calculated. In order to correct the polishing rate automatically, the polishing apparatus may further include a measuring device for measuring the thickness of the polished layer. The measuring device may be connected to the signal processing device 10.

In the above description, although the polishing process is terminated so as to leave the interlayer, the semiconductor wafer may be polished until a lower layer underneath a top layer is exposed outwardly, as shown in FIG. 2B. In the upper part of FIG. 2B, the semiconductor wafer before the polishing process is illustrated, and in the lower part of FIG. 2B, the semiconductor wafer after the polishing process is illustrated. As shown in FIG. 2B, a semiconductor wafer 3 comprises a silicon substrate 3a, an insulating layer 3c made of silicon dioxide (SiO₂) formed on the silicon substrate 3a, and a metal layer 3d formed on the insulating layer 3c. The insulating layer 3c is partially removed to define grooves by etching. When the semiconductor wafer is polished up to an upper surface of the insulating layer 3c, the metal layer 3d remains only in grooves defined by the etching of the insulating layer 3c.

In this case also, the time when an uneven surface of the metal layer 3d is polished to a flat surface is determined by observing current of one of the first and second motors 6 and 7, and the determined time is regarded as a reference time. The time when a certain period of time from the reference time has elapsed is determined as an endpoint in the polishing process. The polishing time during which the polishing surface reaches the insulating layer 3c is calculated on the basis of the polishing rates which have been experienced ahead of time.

According to the method for determining an endpoint in a polishing process of the present invention, since a reference time for setting a certain period of polishing time is the time when an uneven surface is polished to a flat surface, it is possible to comply with a demand for determining various endpoints including, for example, an endpoint for leaving the interlayer and an endpoint for the time when the polishing surface reaches the layer including a different material.

The frictional force at the time when an uneven surface is being polished is different from that at the time when a flat surface is being polished because of the difference in the coefficients of friction therebetween. The frictional force is expressed as the product of the coefficient of friction between the workpiece and the polishing cloth, and the pressing force by which the workpiece is pressed against the polishing cloth. The coefficient of friction depends on materials of the workpiece and the polishing cloth, and surface conditions of the workpiece and the polishing cloth. Even if the workpiece is made of the same material, the workpiece having a rough surface has a larger coefficient of friction than the workpiece having a fine surface. The basic concept of the present invention utilizes a change in the coefficient of friction which occurs when an uneven or irregular surface of the workpiece is changed into a flat surface or when a rough surface of the workpiece is changed into a flat mirror surface.

As is apparent from the above description, the present invention offers the following advantages:
(1) Since the state of the polishing surface of the workpiece can be detected on a real-time basis based on the frictional force between the workpiece and the polishing platen, the endpoint can be determined while polishing is performed.
(2) Since an endpoint on the workpiece can be set to a desired point or timing, this method can meet a demand for determining various endpoints depending on the type of the workpiece.
(3) Since a change in a frictional force can be detected by a change in current of a driving motor for a polishing platen or a holding member such as a top ring, a small change in the frictional force can be detected.
(4) Since the polishing time from the time when an uneven surface of the workpiece is changed into a flat surface can be corrected in succession on the basis of data obtained from the previous polishing operations, it is possible to comply with a change in a polishing rate with time.

In the embodiments, although the polishing time from the reference time to the endpoint is set to a certain period of time, this certain period of time may be in the range of substantially zero second to several minutes.

Although a certain preferred embodiment of the present invention has been shown and described in detail, it should be understood that various changes and modifications may be made therein without departing from the scope of the appended claims.

## Claims

1. A method of determining an endpoint of a process . of polishing a workpiece having an uneven surface, said method comprising:
pressing said uneven surface against a polishing platen while moving said workpiece and said platen relative to each other, and thereby polishing said surface;
detecting a frictional force between said surface and said platen; **characterised by**
determining a reference time as a time of a change in the detected frictional force representative of said uneven surface having been polished to a flat surface; and
determining said endpoint as a certain period of time of continued polishing after said reference time.

2. A method according to claim 1, wherein said change in said frictional force is detected by a change in current of a driving motor for said polishing platen or a holding member for holding said workpiece.

3. A method according to claim 1, wherein said certain period of polishing time is variable and determined based on a polishing amount and 'a polishing time of at least one workpiece which has been previously polished.

4. A method according to claim 3, wherein said certain period of polishing time is determined based on a polishing amount and a polishing time of at least one workpiece which has been polished immediately before polishing the workpiece which is an object for determining said endpoint.

5. A method according to claim 3, wherein said certain period of polishing time is determined based on an average of polishing rates of a plurality of workpieces which have been polished immediately before polishing the workpiece which is an object for determining said endpoint.

6. A method according to claim 3, wherein said workpiece is composed of a substrate and at least one deposited layer on said substrate, and said polishing amount is the polishing amount of the deposited surface layer.

## Patentansprüche

1. Verfahren zum Bestimmen eines Endpunktes eines Prozesses des Polierens eines Werkstücks mit einer nicht-ebenen Oberfläche, wobei das Verfahren folgendes aufweist:
Pressen der erwähnten unebenen Oberfläche gegen eine Polierplatte während das Werkstück und die Platte bezüglich einander bewegt werden, wodurch die Oberfläche poliert wird;
Detektieren einer Reibungskraft zwischen der erwähnten Oberfläche und der Platte; **gekennzeichnet durch**:
Bestimmen einer Bezugszeit als einer Zeit einer Änderung der detektierten Reibungskraft repräsentativ für die auf eine flache Oberfläche polierte unebene Oberfläche; und
Bestimmen des Endpunktes als eine bestimmte Zeitperiode fortgesetzten Polierens nach der erwähnten Bezugszeit.

2. Verfahren nach Anspruch 1, wobei die Änderung in der erwähnten Reibungskraft durch eine Änderung des Stromes eines Antriebsmotors für die Polierplatte oder eines Haltegliedes zum Halten des Werkstückes detektiert wird.

3. Verfahren nach Anspruch 1, wobei die erwähnte bestimmte Periode der Polierzeit variabel ist und bestimmt wird basierend auf einer Poliergröße und einer Polierzeit von mindestens einem Werkstück, das zuvor poliert wurde.

4. Verfahren nach Anspruch 3, wobei die erwähnte bestimmte Periode der Polierzeit bestimmt wird basierend auf einer Poliergröße und einer Polierzeit von mindestens einem Werkstück, welches unmittelbar vor dem Werkstück poliert wurde, welches der Gegenstand oder das Objekt der Bestimmung des erwähnten Endpunktes ist.

5. Verfahren nach Anspruch 3, wobei die bestimmte Periode der Polierzeit bestimmt wird basierend auf einem Durchschnitt der Polierraten oder - geschwindigkeiten von einer Vielzahl von Werkstücken, die unmittelbar vor dem Werkstück poliert wurden, welches ein Objekt oder der Gegenstand der Bestimmung des erwähnten Endpunktes ist.

6. Verfahren nach Anspruch 3, wobei das Werkstück aus einem Substrat aufgebaut ist und mindestens einer auf dem Substrat abgeschiedenen Schicht, und wobei die erwähnte Poliergröße die Poliergröße der abgeschiedenen Oberflächenschicht ist.

## Revendications

1. Procédé pour déterminer une fin d'un processus de polissage d'une pièce à traiter ayant une surface irrégulière, ledit procédé comprenant :
l'appui de ladite surface irrégulière contre une plaque de polissage en déplaçant ladite pièce à traiter et ladite plaque l'une par rapport à l'autre, et donc en polissant ladite surface ;
la détection d'une force de frottement entre ladite surface et ladite plaque ; **caractérisé par**
la détermination d'un temps de référence comme un temps de changement de la force de frottement détectée représentative de ladite surface irrégulière qui vient d'être transformée par polissage en surface plate ; et
la détermination de ladite fin comme une certaine durée de polissage continu après ledit temps de référence.

2. Procédé selon la revendication 1, dans lequel ledit changement de ladite force de frottement est détecté par un changement de courant d'un moteur d'entraînement destiné à ladite plaque de polissage ou à un élément de fixation pour fixer ladite pièce à traiter.

3. Procédé selon la revendication 1, dans lequel ladite certaine durée de polissage est variable et est déterminée en se basant sur une quantité à polir et un temps de polissage d'au moins une pièce à traiter qui a déjà été polie.

4. Procédé selon la revendication 3, dans lequel ladite certaine durée de polissage est déterminée en se basant sur une quantité à polir et un temps de polissage d'au moins une pièce à traiter qui a été polie immédiatement avant le polissage de la pièce à traiter qui est un but pour déterminer ladite fin.

5. Procédé selon la revendication 3, dans lequel ladite certaine durée de polissage est déterminée en se basant sur une moyenne des vitesses de polissage d'une pluralité de pièces à traiter qui ont été polies immédiatement avant le polissage de la pièce à traiter qui est un but pour déterminer ladite fin.

6. Procédé selon la revendication 3, dans lequel ladite pièce à traiter est composée d'un substrat et d'au moins une couche déposée sur le dit substrat, et ladite quantité à polir est la quantité à polir de la couche de surface déposée.
